# FASCICULE DE BREVET EUROPEEN

(11) **EP 3 246 667 B1**
(45) Date de publication et mention de la délivrance du brevet: **26.12.2018**
(21) Numéro de dépôt: 17171076.7
(22) Date de dépôt: 15.05.2017
(51) Int. Cl.: G01D 5/241, G01D 5/24

(54) **DISPOSITIF DE DÉTECTION CAPACITIVE ET DISPOSITIF DE MESURE L'INCLUANT**
KAPAZITIVE ERKENNUNGSVORRICHTUNG, UND DIESE UMFASSENDE MESSVORRICHTUNG
CAPACITIVE DETECTION DEVICE AND MEASUREMENT DEVICE INCLUDING SAME

(30) Priorité: 17.05.2016 FR 1654349
(43) Date de publication de la demande: 22.11.2017
(73) Titulaire: Université Grenoble Alpes, 38400 Saint-Martin-d'Hères (FR)
(72) Inventeur: THIBAULT, Pierre Jean-Yves, 38410 SAINT MARTIN D'URIAGE (FR)
(74) Mandataire: Hautier IP

(56) Documents cités:
- EP-A2- 0 508 143
- WO-A1-2008/101333
- WO-A1-2010/023766
- WO-A2-2009/122061
- US-A1- 2012 111 107

## Description

La présente invention concerne le domaine des dispositifs de détection capacitive et leurs applications à des dispositifs de mesures, en particulier de mesures de déplacements, de mesures de niveaux de fluides, de mesures d'épaisseurs notamment de films de fluides, de détection de présence.

Il est connu de réaliser des détecteurs capacitifs qui comprennent, sur une face d'un ruban en une matière diélectrique, deux électrodes en forme de peignes dont les branches sont disposées alternativement les unes entre les autres ou interdigitées et, sur l'autre face, une électrode de masse. Il est connu que la présence de l'électrode de masse permet, par une mesure à trois fils, d'augmenter la sensibilité du dispositif, et de le protéger d'effets extérieurs parasites. En général, il est considéré que la capacité entre les électrodes interdigitées d'un tel dispositif est la somme d'une contribution diélectrique à l'intérieur du ruban et d'une autre contribution diélectrique sur la partie extérieure du plan des électrodes, qui vient du vide ou d'un fluide.

Par ailleurs, la demande de brevet internationale publiée sous le n° WO2009/122061 décrit un détecteur capacitif dont les caractéristiques permettent d'augmenter la sensibilité de tels détecteurs capacitifs.

La demande de brevet européen publiée sous le N° 0 508 143 décrit un dispositif de mesure capacitive qui comprend une électrode extérieure située à l'extérieur d'un contenant et une électrode intérieure située à l'intérieur de ce contenant. Ces électrodes constituent une capacité de mesure relativement à des fluides circulant dans le contenant. La variable utile mesurée est constituée par le signal électrique issu de cette capacité.

Selon un mode de réalisation, il est proposé un dispositif de détection capacitive qui comprend un détecteur capacitif et une électrode de confinement.

Le détection capacitive comprend un ruban en une matière diélectrique ; au moins un couple d'électrodes comprenant une première électrode en forme de peigne formée sur une première face dudit ruban et comprenant des branches transversales parallèles reliées entre elles par une branche de liaison longitudinale et une deuxième électrode en forme de peigne formée sur ladite première face dudit ruban et comprenant des branches transversales parallèles reliées entre elles par une branche de liaison longitudinale, les branches transversales desdites première et deuxième électrodes étant disposées alternativement les unes entre les autres selon au moins une période déterminée (λ) ; et au moins une troisième électrode en forme de couche formée sur l'autre face dudit ruban, cette troisième électrode et ledit couple d'électrodes recouvrant des zones opposées dudit ruban.

L'électrode de confinement est disposée au moins en partie en regard et à distance dudit couple d'électrodes, cette électrode de confinement étant connectée électriquement à ladite troisième électrode.

Le détecteur capacitif et l'électrode de confinement peuvent être plats et disposés parallèlement.

Le détecteur capacitif et l'électrode de confinement peuvent s'étendre selon des circonférences concentriques.

L'épaisseur (e) du ruban diélectrique peut être inférieure ou égale à ladite période déterminée (λ) divisée par quatre fois PI (soit : λ/4π≥e).

Le rapport, résultant de la division en numérateur de la capacité (C) entre deux branches adjacentes desdites première et deuxième électrodes en présence d'au moins un milieu choisi de permittivité diélectrique (εₘ), interposé entre le détecteur capacitif et l'électrode de confinement, et en dénominateur par la permittivité diélectrique (εₘ) du milieu multipliée par la capacité (Co) entre les deux branches adjacentes des première et deuxième électrodes en présence du vide, est supérieur ou égal à un (soit : C/εₘ.Co≥1).

La distance entre l'électrode de confinement et le détecteur capacitif peut être comprise entre un vingtième et vingt fois ladite période déterminée (λ).

Le dispositif peut comprendre un circuit électronique de mesure auquel sont reliées lesdites première et seconde électrodes, la troisième électrode et l'électrode de confinement étant placées à un même potentiel de référence, le circuit électronique de mesure comprenant un dispositif de mesure relié aux première et seconde électrodes et apte à délivrer un signal électrique relatif à la mesure de la capacité entre les première et seconde électrodes.

Il est également proposé un dispositif de mesure de niveau d'un fluide ou d'épaisseur d'un film de fluide, qui comprend un dispositif de détection tel que défini ci-dessus, dans lequel au moins une partie du liquide est présente entre le détecteur capacitif et l'électrode de confinement ; et un moyen pour mesurer la capacité entre lesdites première et seconde électrodes du couple d'électrodes du détecteur capacitif.

Il est également proposé un dispositif de mesure de déplacement d'une première pièce par rapport à une deuxième pièce, qui comprend un dispositif de détection tel que défini ci-dessus, dans lequel le détecteur capacitif est solidaire de l'une des pièces et l'électrode de confinement est solidaire de l'autre pièce ; et un moyen pour mesurer la capacité entre lesdites première et seconde électrodes du couple d'électrodes du détecteur capacitif.

Lesdites pièces peuvent être aptes à se déplacer dans le sens qui éloigne et/ou rapproche le détecteur capacitif et l'électrode de confinement.

Lesdites pièces peuvent être aptes à se déplacer dans le sens qui augmente ou réduit le recouvrement de l'électrode de confinement par rapport au détecteur capacitif.

Il est également proposé un dispositif de mesure de déplacement d'une première pièce par rapport à une deuxième pièce, qui comprend un dispositif de détection tel que défini ci-dessus, dans lequel le détecteur capacitif et l'électrode de confinement sont solidaires de l'une des pièces, l'autre pièce comprenant un élément diélectrique solidaire de l'autre pièce et engagé entre le détecteur capacitif et l'électrode de confinement ; et un moyen pour mesurer la capacité entre lesdites première et seconde électrodes du couple d'électrodes du détecteur capacitif.

Un dispositif de détection et des dispositifs de mesure vont maintenant être décrits à titre d'exemples non limitatifs, illustrés par le dessin annexé dans lequel :
- la figure 1 représente, en perspective, un dispositif de détection, incluant un détecteur capacitif ;
- la figure 2 représente une vue de côté du détecteur capacitif de la figure 1 ;
- la figure 3 représente une coupe longitudinale du détecteur capacitif de la figure 1 ;
- la figure 4 représente un schéma électronique d'un circuit électronique auquel est relié le dispositif de détection de la figure 1 ; et
- les figures 5 à 9 représentent des dispositifs de mesure incluant le dispositif de détection précité de la figure 1.

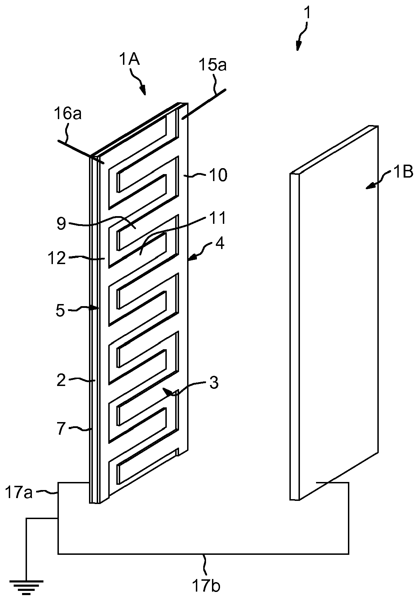

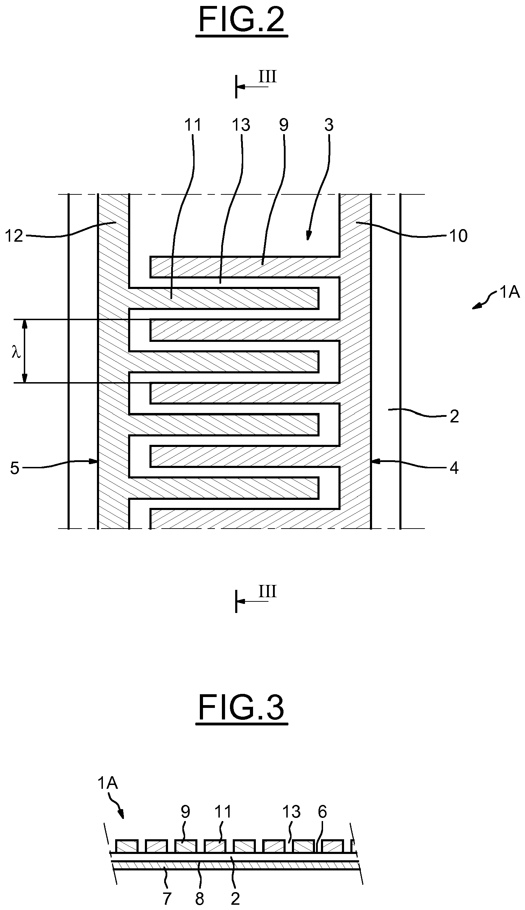

Sur les figures 1 à 3 est illustré un dispositif de détection capacitive 1 qui comprend un détecteur capacitif 1A et une électrode de confinement 1B.

Le détecteur capacitif 1A comprend un ruban longitudinal 2 en une matière diélectrique, souple ou rigide, un couple 3 d'électrodes comprenant une première électrode 4 et une deuxième électrode 5 formées sur une face 6 du ruban diélectrique 2, et une troisième électrode 7 formée sur l'autre face 8 du ruban diélectrique 2.

La première électrode 4 est en forme de peigne et comprend des branches transversales parallèles 9, régulièrement espacées et reliées entre elles par une branche de liaison longitudinale 10.

La deuxième électrode 5 est en forme de peigne et comprend des branches transversales parallèles 11, régulièrement espacées et reliées entre elles par une branche de liaison longitudinale 12.

Les branches transversales 9 et 11 des première et deuxième électrodes 4 et 5 sont disposées alternativement les unes entre les autres, présentent des largeurs égales et des longueurs égales et sont espacées à égales distances les unes des autres, les branches transversales 9 s'étendant en direction de la branche de liaison longitudinale 12 et les branches transversales parallèles 11 s'étendant en direction de la branche de liaison longitudinale 10. Une telle disposition est appelée une structure interdigitée.

Ainsi, les branches transversales 9 et 11 sont disposées selon une période déterminée λ qui comprend l'addition d'une largeur des branches 9 de l'électrode 4, d'une largeur des branches 11 de l'électrode 5 et de deux espaces 13 entre deux branches adjacentes 9 et 11.

La troisième électrode 7 se présente sous la forme d'une couche qui, avantageusement, couvre une zone de la face 8 du ruban diélectrique 2 opposée à la zone de la face 6 du ruban diélectrique 2 couverte par le couple 3 d'électrodes interdigitées 4 et 5.

Par exemple, le ruban diélectrique 2 peut être en une matière plastique telle qu'un polyimide comme du Kapton, ou telle qu'un polytétrafluoroéthylène (Teflon) et les électrodes 4, 5 et 7 peuvent être formées par des couches en une matière métallique telle que du cuivre ou de l'or. Les faces opposées du détecteur capacitif 1A peuvent être recouvertes des couches fines de protection recouvrant le couple 3 d'électrodes interdigitées 4 et 5 et l'électrode 7, ces couches fines de protection étant par exemple en une matière diélectrique.

L'électrode de confinement 1B est formée par une plaque en une matière conductrice de l'électricité, formée par exemple d'une feuille métallique en cuivre ou en or. L'électrode de confinement 1B est située du côté ou en vis-à-vis de la face 6 du ruban 2 portant le couple 3 d'électrodes interdigitées 4 et 5 et est disposée parallèlement et à distance du détecteur capacitif 1A, de sorte qu'il existe un espace d'épaisseur constante entre le détecteur capacitif 1A et l'électrode de confinement 1B.

Le ruban diélectrique 2 peut être, par exemple, en une matière plastique telle qu'un polyimide comme du Kapton, ou telle qu'un polytétrafluoroéthylène (Teflon).

Avantageusement, l'épaisseur e du ruban diélectrique 2 est inférieure ou égale à ladite période déterminée λ divisée par quatre fois PI, soit la formule (1) : λ/4π≥e.

Le rapport résultant de la division en numérateur de la capacité C entre deux branches adjacentes 9 et 11 des première et deuxième électrodes 4 et 5 en présence d'au moins un milieu choisi de permittivité diélectrique εₘ, interposé entre le détecteur capacitif 1A et l'électrode de confinement 1B, et en dénominateur par la permittivité diélectrique (εₘ) du milieu multipliée par la capacité (Co) entre les deux branches adjacentes 9 et 11 des première et deuxième électrodes 4 et 5 en présence du vide est supérieur ou égal à un, soit la formule (2) : C/εₘ.Co≥1.

La distance entre l'électrode de confinement 1B et le détecteur capacitif 1A peut être avantageusement comprise entre un vingtième et vingt fois ladite période déterminée λ.

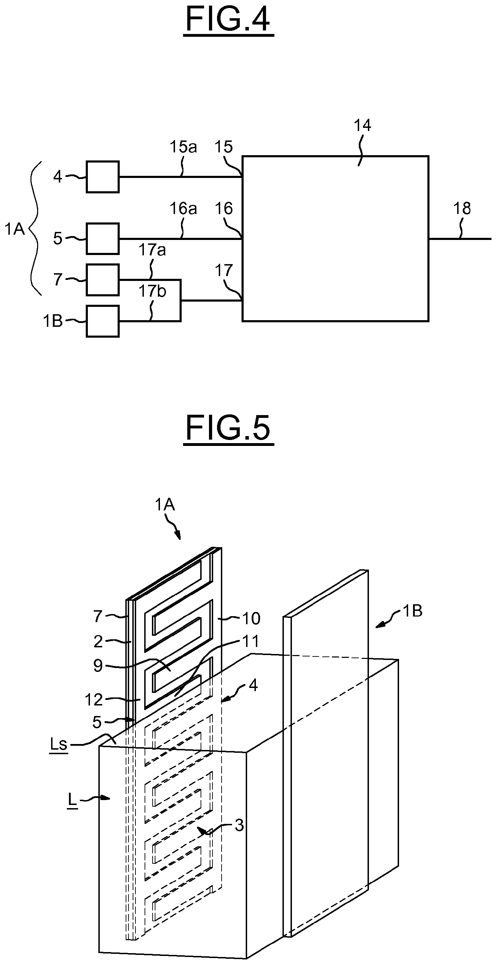

Comme illustré sur la figure 4, le dispositif de détection capacitive 1 est relié à un circuit électronique de mesure 14. Les première et seconde électrodes interdigitées 4 et 5 sont respectivement reliées à des entrées 15 et 16 du circuit électronique de mesure 14 par des fils électriques 15a et 16a. La troisième électrode 7 et l'électrode de confinement 1B sont reliées à une même entrée 17 du circuit électronique de mesure 14 par des fils électriques 17a et 17b, de sorte que la troisième électrode 7 et l'électrode de confinement 1B sont reliées entre elles.

Le circuit électronique de mesure 14 est adapté pour que la troisième électrode 7 et l'électrode de confinement 1B, via l'entrée 17, soient à un potentiel de référence. Le circuit électronique de mesure 14 comprend un dispositif de mesure relié aux première et seconde électrodes interdigitées 4 et 5, via les entrées 15 et 16, et apte à délivrer sur une sortie 18 un signal électrique relatif à la mesure de la capacité mutuelle entre les première et seconde électrodes interdigitées 4 et 5. C'est donc la valeur de ce signal électrique qui constitue la variable utile mesurée.

Par exemple, l'électrode 5 étant référencée par rapport à la troisième électrode 7 et l'électrode de confinement 1B connectées entre elles, le dispositif de mesure peut ainsi être un dispositif dit à trois terminaux, et peut faire intervenir une mesure par un pont, dit de Blumlein.

La présence de l'électrode de confinement 1B influence les lignes de champ magnétique dans l'environnement du couple 3 d'électrodes interdigitées 4 et 5 du détecteur capacitif 1A, en induisant une répartition des lignes de champ entre les électrodes 4 et 5 du détecteur capacitif 1A et aussi entre des électrodes 4 et 5 et l'électrode de confinement 1B, de sorte que la mesure de la capacité mutuelle entre les électrodes interdigitées 4 et 5 dépend ou varie en fonction de la distance entre le détecteur capacitif 1A et l'électrode de confinement 1B, et/ou du recouvrement relatif entre le détecteur capacitif 1A et l'électrode de confinement 1B et/ou du milieu diélectrique établi entre le détecteur capacitif 1A et l'électrode de confinement 1B.

Le dispositif de détection capacitive 1 peut être appliqué dans de nombreux domaines.

Selon une application illustrée sur la figure 5, le dispositif de détection capacitive 1 peut être mis en oeuvre pour mesurer le niveau d'un liquide dans un réservoir ou dans une conduite.

Pour cela, le détecteur capacitif 1A et l'électrode de confinement sont placés substantiellement verticalement, les branches 9 et 11 des électrodes 4 et 5 étant horizontales, de sorte qu'une lame L de liquide s'étende entre eux. Avantageusement, l'électrode de confinement 1B recouvre à distance toute la surface du détecteur capacitif 1A.

Le milieu diélectrique établi entre le détecteur capacitif 1A et l'électrode de confinement 1B est défini par une partie du liquide, sous la forme d'une lame L de liquide, qui recouvre une portion inférieure du couple 3 d'électrodes interdigitées 4 et 5 du détecteur capacitif 1A et de l'électrode de confinement 1B et, au-dessus de la lame L par un gaz.

Dans la formule (2) précitée, la permittivité diélectrique εₘ du milieu choisi est celle du liquide.

Le nombre de branches horizontales 9 et 11 des électrodes interdigitées 4 et 5, recouvertes par la lame L de liquide, dépend du niveau de la surface libre Ls de cette lame L du liquide et donc du niveau de la surface libre du liquide dans le réservoir ou la conduite.

Ainsi, la valeur mesurée de la capacité mutuelle entre les première et seconde électrodes interdigitées 4 et 5 est une fonction de la longueur de la portion inférieure du couple 3 d'électrodes interdigitées 4 et 5 du détecteur capacitif 1A, recouverte par la lame L de liquide, et donc, substantiellement du nombre de branches horizontales 9 et 11 des électrodes interdigitées 4 et 5, recouvertes par la lame L de liquide.

Cette fonction étant programmée, le circuit électronique de mesure 14 est apte à délivrer à sa sortie 18 la situation et des valeurs de déplacements du niveau de la surface libre Ls de la lame L de liquide et donc la situation du niveau du liquide dans le réservoir. Substantiellement, la variation de la valeur mesurée de la capacité mutuelle entre les première et seconde électrodes interdigitées 4 et 5 est proportionnelle à la longueur immergée du détecteur capacitif 1A dans le liquide. Par calcul, le circuit électronique de mesure 14 peut aussi être apte à délivrer la vitesse des déplacements de la surface libre Ls de la lame L de liquide.

Selon un exemple de mise en place, l'électrode de confinement 1B peut être suspendue dans le réservoir en étant tendue. Selon une variante, le détecteur capacitif 1A peut être suspendu dans le réservoir ou la conduite en étant tendu. Selon une autre option, le détecteur capacitif 1A peut être accolé à une paroi intérieure du réservoir ou de la conduite. Selon une autre option, le détecteur capacitif 1A peut être accolé à une paroi extérieure du réservoir ou de la conduite à condition que cette paroi ne soit pas métallique.

Selon une variante d'utilisation, le dispositif de mesure 1 peut aussi être appliqué à la détermination du niveau de toutes matières en poudre, en particules ou en grains se comportant de façon équivalente à un liquide.

Selon une variante d'application, le dispositif de détection capacitive 1 peut être mis en oeuvre pour mesurer l'épaisseur d'un film en une matière diélectrique, par exemple d'un film de liquide s'étendant entre le détecteur capacitif 1A et l'électrode de confinement 1B.

La valeur mesurée de la capacité mutuelle entre les première et seconde électrodes interdigitées 4 et 5 est une fonction de l'épaisseur du film. Cette fonction étant programmée, le circuit électronique de mesure 14 est apte à délivrer à sa sortie 18 la valeur de l'épaisseur du film.

Selon une variante d'application, le dispositif de détection capacitive 1 peut être mis en oeuvre pour détecter la présence d'un brouillard, lorsque la valeur mesurée de la capacité mutuelle entre les première et seconde électrodes interdigitées 4 et 5 passe un seuil prédéterminé, et/ou la densité d'un tel brouillard, la valeur mesurée de la capacité mutuelle entre les première et seconde électrodes interdigitées 4 et 5 étant une fonction de cette densité.

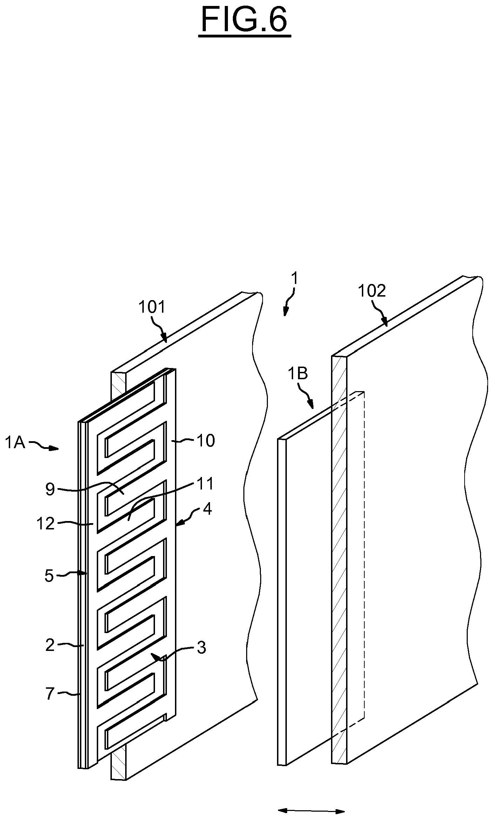

Selon une autre application illustrée sur la figure 6, le détecteur capacitif 1A et l'électrode de confinement 1B, disposés parallèlement, sont respectivement solidaires de pièces 101 et 102 mobiles dans le sens du rapprochement et/ou de l'éloignement du détecteur capacitif 1A et de l'électrode de confinement 1B, le milieu diélectrique entre le détecteur capacitif 1A et l'électrode de confinement 1B étant déformable, par exemple un gaz. Avantageusement, l'électrode de confinement 1B recouvre à distance toute la surface du détecteur capacitif 1A.

Dans la formule (2) précitée, la permittivité diélectrique εₘ du milieu choisi est celle du milieu diélectrique établi entre le détecteur capacitif 1A et l'électrode de confinement 1B.

La valeur mesurée de la capacité mutuelle entre les première et seconde électrodes interdigitées 4 et 5 est une fonction de la distance entre le détecteur capacitif 1A et l'électrode de confinement 1B. Cette fonction étant programmée, le circuit électronique de mesure 14 est apte à délivrer à sa sortie 18 la position et des valeurs de déplacements des pièces 101 et 102 l'une par rapport à l'autre. Par calcul, le circuit électronique de mesure 14 peut aussi être apte à délivrer la vitesse de des déplacements des pièces 101 et 102 l'une par rapport à l'autre.

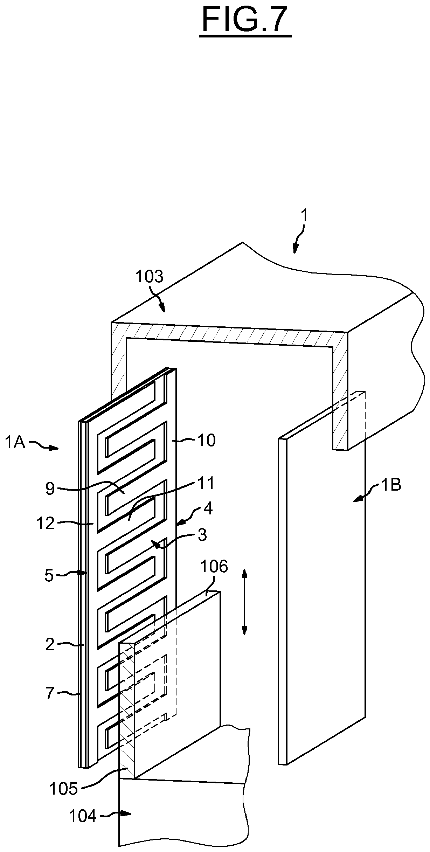

Selon une autre application illustrée sur la figure 7, le détecteur capacitif 1A et l'électrode de confinement 1B, disposés parallèlement et en vis-à-vis, sont solidaires d'une pièce 103. Avantageusement, l'électrode de confinement 1B recouvre à distance toute la surface du détecteur capacitif 1A.

Une pièce 104 est munie d'une lame diélectrique 105 qui est engagée partiellement entre le détecteur capacitif 1A et l'électrode de confinement 1B et qui est disposée parallèlement à et à distance de ces derniers.

Les pièces sont mobiles l'une par rapport à l'autre dans la direction longitudinale du détecteur capacitif 1A. La lame diélectrique 105 présente un bord transversal d'extrémité 106 parallèle aux branches 8 et 9 des électrodes interdigitées 4 et 5. Avantageusement, la lame diélectrique 105 recouvre à distance toute la surface du détecteur capacitif 1A.

Dans cette application, on retrouve une situation substantiellement équivalente à la situation décrite en référence à la figure 5, la lame diélectrique 105 jouant un rôle substantiellement équivalent à celui de la lame L de liquide.

Ainsi, la valeur mesurée de la capacité mutuelle entre les première et seconde électrodes interdigitées 4 et 5 est une fonction de la longueur de la portion du couple 3 d'électrodes interdigitées 4 et 5 du détecteur capacitif 1A, recouverte par la lame diélectrique 105, et donc, substantiellement du nombre de branches horizontales 9 et 11 des électrodes interdigitées 4 et 5, recouvertes par la lame diélectrique 105.

Cette fonction étant programmée, le circuit électronique de mesure 14 est apte à délivrer à sa sortie 18 la position longitudinale de la lame diélectrique 105 par rapport au détecteur capacitif 1A et donc la position longitudinale et des valeurs de déplacements des pièces 103 et 104 l'une par rapport à l'autre. Substantiellement, la variation de la valeur mesurée de la capacité mutuelle entre les première et seconde électrodes interdigitées 4 et 5 est proportionnelle à la longueur de la lame diélectrique 105 engagée entre le détecteur capacitif 1A et l'électrode de confinement 1B. Par calcul, le circuit électronique de mesure 14 peut aussi être apte à délivrer la vitesse des déplacements des pièces 103 et 104 l'une par rapport à l'autre.

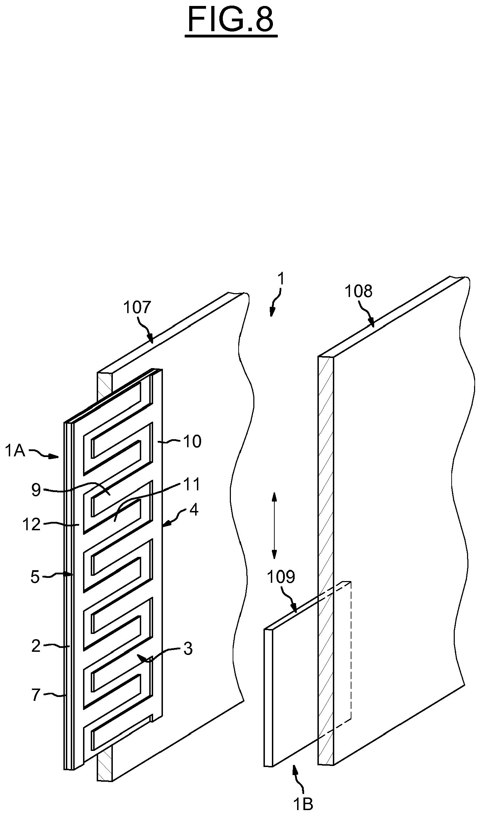

Selon une autre application illustrée sur la figure 8, le détecteur capacitif 1A et l'électrode de confinement 1B, disposés parallèlement et en vis-à-vis, sont respectivement solidaires de pièces 107 et 108 mobiles longitudinalement l'une par rapport à l'autre.

L'électrode de confinement 1B présente un bord d'extrémité 109 parallèle aux branches 9 et 11 des électrodes interdigitées 4 et 5 et est disposée de façon à recouvrir à distance une portion d'extrémité du détecteur capacitif 1A.

La valeur mesurée de la capacité mutuelle entre les première et seconde électrodes interdigitées 4 et 5 est une fonction de la longueur de la portion du couple 3 d'électrodes interdigitées 4 et 5 du détecteur capacitif 1A, recouverte à distance par l'électrode de confinement 1B, et donc de la position longitudinale des pièces 107 et 108 l'une par rapport à l'autre.

Cette fonction étant programmée, le circuit électronique de mesure 14 est apte à délivrer à sa sortie 18 la position longitudinale de l'électrode de confinement 1B par rapport au détecteur capacitif 1A et donc la position longitudinale et des valeurs de déplacements des pièces 107 et 108 l'une par rapport à l'autre. Substantiellement, la variation de la valeur mesurée de la capacité mutuelle entre les première et seconde électrodes interdigitées 4 et 5 est proportionnelle à la valeur du recouvrement entre le détecteur capacitif 1A et l'électrode de confinement 1B. Par calcul, le circuit électronique de mesure 14 peut aussi être apte à délivrer la vitesse des déplacements des pièces 107 et 108 l'une par rapport à l'autre.

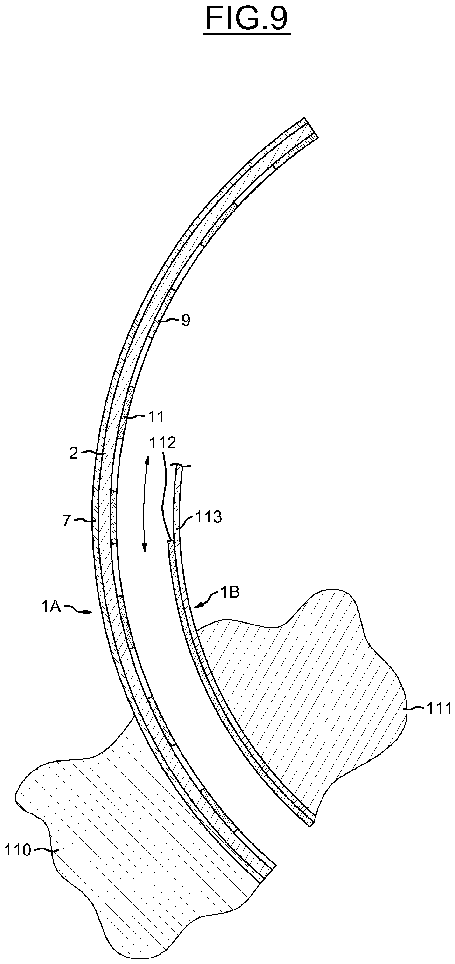

Selon une autre application illustrée sur la figure 9, les pièces 110 et 111 sont mobiles en rotation l'une par rapport à l'autre selon un axe de rotation. Dans ce cas, le détecteur capacitif 1A et l'électrode de confinement 1B sont respectivement solidaires des pièces 110 et 111 et sont formées de façon annulaire selon des circonférences coaxiales aux pièces 110 et 111, le détecteur capacitif 1A et l'électrode de confinement 1B étant radialement en vis-à-vis.

Les branches 9 et 11 des électrodes interdigitées s'étendent axialement. L'électrode de confinement 1B présente un bord axial d'extrémité 112 parallèle aux branches 9 et 11 des électrodes interdigitées 4 et 5 et est disposée de façon à recouvrir à distance une portion d'extrémité du détecteur capacitif 1A.

Dans une variante de réalisation, le détecteur capacitif 1A et l'électrode de confinement 1B pourraient être disposés axialement en vis-à-vis, les branches 9 et 11 des électrodes interdigitées s'étendant alors radialement et le bord 112 s'étendant alors radialement.

La valeur mesurée de la capacité mutuelle entre les première et seconde électrodes interdigitées 4 et 5 est une fonction de la longueur de l'arc de la portion du couple 3 d'électrodes interdigitées 4 et 5 du détecteur capacitif 1A, recouverte à distance par l'arc de l'électrode de confinement 1B, et donc de la position angulaire des pièces 107 et 108 l'une par rapport à l'autre.

Cette fonction étant programmée, le circuit électronique de mesure 14 est apte à délivrer à sa sortie 18 la position angulaire de l'électrode de confinement 1B par rapport au détecteur capacitif 1A et donc la position angulaire et des valeurs de déplacements angulaires des pièces 107 et 108 l'une par rapport à l'autre. Par calcul, le circuit électronique de mesure 14 peut aussi être apte à délivrer la vitesse de rotation des pièces 107 et 108 l'une par rapport à l'autre.

Dans les applications qui viennent d'être décrites, l'électrode de confinement 1B peut être fixée sur la pièce qui la porte par l'intermédiaire d'une feuille 113 en une matière diélectrique, par exemple en une matière plastique telle qu'un polyimide comme du Kapton, ou tel qu'un polytétrafluoroéthylène (Teflon), afin d'éviter que la matière de la pièce qui porte l'électrode de confinement 1B empêche ou influence les mesures effectuées. L'électrode de confinement 1B peut être constituée par une partie métallique de la pièce, à la condition, notamment dans les applications des figures 8 et 9, de l'existence des bords 109 et 112 qui déterminent une extrémité de la surface de l'électrode de confinement 1B, permettant les mesures, en regard du détecteur capacitif 1A, et à la condition que la surface de la pièce, qui suit ce bord, soit plus éloignée du détecteur capacitif 1A.

## Revendications

1. Dispositif de détection capacitive comprenant :
un détecteur capacitif (1A) comprenant
- un ruban en une matière diélectrique (2),
- au moins un couple (3) d'électrodes comprenant une première électrode (4) en forme de peigne formée sur une première face dudit ruban et comprenant des branches transversales parallèles (9) reliées entre elles par une branche de liaison longitudinale (10) et une deuxième électrode (5) en forme de peigne formée sur ladite première face dudit ruban et comprenant des branches transversales parallèles (11) reliées entre elles par une branche de liaison longitudinale (12), les branches transversales desdites première et deuxième électrodes étant disposées alternativement les unes entre les autres selon au moins une période déterminée (λ), et
- au moins une troisième électrode (7) en forme de couche formée sur l'autre face dudit ruban, cette troisième électrode (7) et ledit couple d'électrodes recouvrant des zones opposées dudit ruban ;
le dispositif étant **caractérisé en ce qu'**il comprend en outre une électrode de confinement (1B) disposée au moins en partie en regard et à distance dudit couple d'électrodes, cette électrode de confinement étant connectée électriquement à ladite troisième électrode.

2. Dispositif selon la revendication 1, dans lequel le détecteur capacitif et l'électrode de confinement sont plats et disposés parallèlement.

3. Dispositif selon la revendication 1, dans lequel le détecteur capacitif et l'électrode de confinement s'étendent selon des circonférences concentriques.

4. Dispositif selon l'une quelconque des revendications précédentes, dans lequel l'épaisseur (e) du ruban diélectrique (2) est inférieure ou égale à ladite période déterminée (λ) divisée par quatre fois PI, soit : λ/4π≥e ; et dans lequel le rapport, résultant de la division en numérateur de la capacité (C) entre deux branches adjacentes (9, 11) desdites première et deuxième électrodes en présence d'au moins un milieu choisi de permittivité diélectrique (εₘ), interposé entre le détecteur capacitif (1A) et l'électrode de confinement (1B), et en dénominateur par la permittivité diélectrique (εₘ) du milieu multipliée par la capacité (Co) entre les deux branches adjacentes des première et deuxième électrodes en présence du vide, est supérieur ou égal à un, soit : C/εₘ.Co≥1.

5. Dispositif selon l'une quelconque des revendications précédentes, dans lequel la distance entre l'électrode de confinement (1B) et le détecteur capacitif (1A) est comprise entre un vingtième et vingt fois ladite période déterminée (λ).

6. Dispositif selon l'une quelconque des revendications précédentes, comprenant un circuit électronique de mesure (14) auquel sont reliées lesdites première et seconde électrodes (4, 5, 7, 1B), la troisième électrode (7) et l'électrode de confinement (1B) étant placées à un même potentiel de référence, le circuit électronique de mesure (14) comprenant un dispositif de mesure relié aux première et seconde électrodes (4, 5) et apte à délivrer un signal électrique relatif à la mesure de la capacité entre les première et seconde électrodes (4, 5).

7. Dispositif de mesure de niveau d'un fluide ou d'épaisseur d'un film de fluide comprenant :
un dispositif de détection (1) selon l'une des revendications 1 à 6, dans lequel au moins une partie du liquide est présente entre le détecteur capacitif (1A) et l'électrode de confinement (1B) ;
et un moyen (14) pour mesurer la capacité entre lesdites première et seconde électrodes du couple d'électrodes du détecteur capacitif (1A).

8. Dispositif de mesure de déplacement d'une première pièce par rapport à une deuxième pièce, comprenant :
un dispositif de détection (1) selon l'une des revendications 1 à 6, dans lequel le détecteur capacitif (1A) est solidaire de l'une des pièces et l'électrode de confinement (1B) est solidaire de l'autre pièce ;
et un moyen (14) pour mesurer la capacité entre lesdites première et seconde électrodes du couple d'électrodes du détecteur capacitif (1A).

9. Dispositif selon la revendication 8, dans lequel lesdites pièces sont aptes à se déplacer dans le sens qui éloigne et/ou rapproche le détecteur capacitif et l'électrode de confinement.

10. Dispositif selon la revendication 8, dans lequel lesdites pièces sont aptes à se déplacer dans le sens qui augmente ou réduit le recouvrement de l'électrode de confinement (1B) par rapport au détecteur capacitif (1A).

11. Dispositif de mesure de déplacement d'une première pièce par rapport à une deuxième pièce, comprenant :
un dispositif de détection (1) selon l'une des revendications 1 à 6, dans lequel le détecteur capacitif (1A) et l'électrode de confinement (1B) sont solidaires de l'une des pièces, l'autre pièce comprenant un élément diélectrique solidaire de l'autre pièce et engagé entre le détecteur capacitif (1A) et l'électrode de confinement (1B) ;
et un moyen (14) pour mesurer la capacité entre lesdites première et seconde électrodes du couple d'électrodes du détecteur capacitif (1A).

## Patentansprüche

1. Kapazitive Detektionsvorrichtung, umfassend:
einen kapazitiven Sensor (1A), umfassend
- einen Streifen aus einem dielektrischen Material (2),
- mindestens ein Elektrodenpaar (3), das eine erste Elektrode (4) in Kammform umfasst, die auf einer ersten Seite des Streifens gebildet ist und parallele Querzweige (9) umfasst, die über einen Längsverbindungszweig (10) miteinander verbunden sind, und eine zweite Elektrode (5) in Kammform, die auf der ersten Seite des Streifens gebildet ist und parallele Querzweige (11) umfasst, die über einen Längsverbindungszweig (12) miteinander verbunden sind, wobei die Querzweige der ersten und zweiten Elektrode gemäß mindestens einer bestimmten Periode (λ) abwechselnd zwischen einander angeordnet sind, und
- mindestens eine dritte Elektrode (7) in Schichtform, die auf der anderen Seite des Streifens gebildet ist, wobei diese dritte Elektrode (7) und das Elektrodenpaar gegenüberliegende Zonen des Streifens bedecken;
wobei die Vorrichtung **dadurch gekennzeichnet ist, dass** sie weiter eine Grenzelektrode (1B) umfasst, die mindestens zum Teil dem Elektrodenpaar zugewandt und von demselben beabstandet angeordnet ist, wobei diese Grenzelektrode elektrisch mit der dritten Elektrode verbunden ist.

2. Vorrichtung nach Anspruch 1, wobei der kapazitive Sensor und die Grenzelektrode flach und parallel angeordnet sind.

3. Vorrichtung nach Anspruch 1, wobei sich der kapazitive Sensor und die Grenzelektrode entlang konzentrischen Umfängen erstrecken.

4. Vorrichtung nach einem der vorstehenden Ansprüche, wobei die Dicke (e) des dielektrischen Streifens (2) kleiner oder gleich der bestimmten Periode (λ) dividiert durch vier mal PI ist, das heißt: λ/4π≥e; und wobei das das Verhältnis, das aus der Division im Zähler der Kapazität (C) zwischen zwei benachbarten Zweigen (9, 11) der ersten und zweiten Elektrode in Gegenwart von mindestes einem ausgewählten dielektrischen Permittivitätsmedium (εₘ), das zwischen dem kapazitiven Sensor (1A) und der Grenzelektrode (1B) eingefügt ist, und im Nenner durch die dielektrische Permittivität (εₘ) des Mediums multipliziert mit der Kapazität (Co) zwischen den zwei benachbarten Zweigen der ersten und zweiten Elektrode in Gegenwart von Vakuum resultiert, größer oder gleich eins ist, das heißt: C/εₘ.Co≥1.

5. Vorrichtung nach einem der vorstehenden Ansprüche, wobei der Abstand zwischen der Grenzelektrode (1B) und dem kapazitiven Sensor (1A) im Bereich zwischen einem Zwanzigstel und zwanzigmal der bestimmten Periode (λ) beträgt.

6. Vorrichtung nach einem der vorstehenden Ansprüche, die eine elektronische Messschaltung (14) umfasst, mit der die erste und zweite Elektrode (4, 5, 7, 1B) verbunden sind, wobei die dritte Elektrode (7) und die Grenzelektrode (1B) auf ein und demselben Referenzpotential liegen, wobei die elektronische Messschaltung (14) eine Messvorrichtung umfasst, die mit der ersten und zweiten Elektrode (4, 5) verbunden und dazu in der Lage ist, ein elektrisches Signal zu liefern, das sich auf die Messung der Kapazität zwischen der ersten und zweiten Elektrode (4, 5) bezieht.

7. Vorrichtung zum Messen des Füllstands eines Fluids oder der Dicke eines Fluidfilms, umfassend:
eine Detektionsvorrichtung (1) nach einem der Ansprüche 1 bis 6, wobei sich mindestens ein Teil der Flüssigkeit zwischen dem kapazitiven Sensor (1A) und der Grenzelektrode (1B) befindet;
und ein Mittel (14) zum Messen der Kapazität zwischen der ersten und zweiten Elektrode des Elektrodenpaares des kapazitiven Sensors (1A).

8. Vorrichtung zum Messen von Bewegung eines ersten Teils in Bezug auf ein zweites Teil, umfassend:
eine Detektionsvorrichtung (1) nach einem der Ansprüche 1 bis 6, wobei der kapazitive Sensor (1A) fest mit einem der Teile verbunden ist, und die Grenzelektrode (1B) fest mit dem anderen Teil verbunden ist;
und ein Mittel (14) zum Messen der Kapazität zwischen der ersten und zweiten Elektrode des Elektrodenpaares des kapazitiven Sensors (1A).

9. Vorrichtung nach dem Anspruch 8, wobei die Teile dazu in der Lage sind, sich in der Richtung zu bewegen, die den kapazitiven Sensor und die Grenzelektrode entfernt und/oder annähert.

10. Vorrichtung nach Anspruch 8, wobei die Teile dazu in der Lage sind, sich in der Richtung zu bewegen, die die Abdeckung der Grenzelektrode (1B) in Bezug auf den kapazitiven Sensor (1A) vergrößert oder verkleinert.

11. Vorrichtung zum Messen der Bewegung eines ersten Teils in Bezug auf ein zweites Teil, umfassend:
eine Detektionsvorrichtung (1) nach einem der Ansprüche 1 bis 6, wobei der kapazitive Sensor (1A) und die Grenzelektrode (1B) fest mit einem der Teile verbunden sind, wobei das andere Teil ein dielektrisches Element umfasst, das fest mit dem anderen Teil verbunden ist und zwischen dem kapazitiven Sensor (1A) und der Grenzelektrode (1B) eingreift;
und ein Mittel (14) zum Messen der Kapazität zwischen der ersten und zweiten Elektrode des Elektrodenpaares des kapazitiven Sensors (1A).

## Claims

1. Capacitive detection device comprising:
a capacitive detector (1A) comprising
- a strip made of a dielectric material (2),
- at least one pair (3) of electrodes comprising a first electrode (4) in the form of a comb formed on a first face of said strip and comprising parallel transverse branches (9) connected to each other by a longitudinal connecting branch (10) and a second electrode (5) in the form of a comb formed on said first face of said strip and comprising parallel transverse branches (11) connected to each other by a longitudinal connecting branch (12), the transverse branches of said first and second electrodes being arranged alternatively between each other according to at least one determined period (A), and
- at least one third electrode (7) in the form of a layer formed on the other face of said strip, this third electrode (7) and said pair of electrodes covering opposite zones of said strip;
the device being **characterised in that** it further comprises a containment electrode (1B) arranged at least partially facing and remote from said pair of electrodes, this containment electrode being electrically connected to said third electrode.

2. Device according to claim 1, wherein the capacitive detector and the containment electrode are flat and arranged parallel.

3. Device according to claim 1, wherein the capacitive detector and the containment electrode extend along concentric circumferences.

4. Device according to any one of the preceding claims, wherein the thickness (e) of the dielectric strip (2) is less than or equal to said determined period (λ) divided by four times PI, that is: λ/4π≥e; and wherein the ratio, resulting from the division in the numerator of the capacity (C) between two adjacent branches (9, 11) of said first and second electrodes in the presence of at least one selected environment of dielectric permittivity (εₘ), inserted between the capacitive detector (1A) and the containment electrode (1B), and in the denominator by the dielectric permittivity (εₘ) of the environment multiplied by the capacity (Co) between the two adjacent branches of the first and second electrodes in the presence of the vacuum, is greater than or equal to one, that is: C/εₘ.Co≥1.

5. Device according to any one of the preceding claims, wherein the distance between the containment electrode (1B) and the capacitive detector (1A) is between one twentieth and twenty times said determined period (A).

6. Device according to any one of the preceding claims, comprising an electronic measuring circuit (14) to which are connected said first and second electrodes (4, 5, 7, 1B), the third electrode (7) and the containment electrode (1B) being placed at one same reference potential, the electronic measuring circuit (14) comprising a measuring device connected to the first and second electrodes (4, 5) and capable of delivering an electric signal relating to the measurement of the capacity between the first and second electrodes (4, 5).

7. Device for measuring the level of a fluid or a thickness of a fluid film comprising:
a detection device (1) according to one of claims 1 to 6, wherein at least one part of the liquid is present between the capacitive detector (1A) and the containment electrode (1B);
and a means (14) to measure the capacity between said first and second electrodes of the pair of electrodes of the capacitive detector (1A).

8. Device for measuring the movement of a first part with respect to a second part, comprising:
a detection device (1) according to one of claims 1 to 6, wherein the capacitive detector (1A) is secured to one of the parts and the containment electrode (1B) is secured to the other part;
and a means (14) to measure the capacity between said first and second electrodes of the pair of electrodes of the capacitive detector (1A).

9. Device according to claim 8, wherein said parts are capable of being moved in the direction which extends and/or approaches the capacitive detector and the containment electrode.

10. Device according to claim 8, wherein said parts are capable of being moved in the direction which increases or reduces the covering of the containment electrode (1B) with respect to the capacitive detector (1A).

11. Device for measuring the movement of a first part with respect to a second part, comprising:
a detection device (1) according to one of claims 1 to 6, wherein the capacitive detector (1A) and the containment electrode (1B) are secured to one of the parts, the other part comprising a dielectric element secured to the other part and engaged between the capacitive detector (1A) and the containment electrode (1B);
and a means (14) for measuring the capacity between said first and second electrodes of the pair of electrodes of the capacitive detector (1A).
